(19) Europäisches Patentamt

European Patent Office

Office européen des brevets

(11) **EP 0 631 146 B1**

(12) **FASCICULE DE BREVET EUROPEEN**

(45) Date de publication et mention
de la délivrance du brevet:
**02.02.2000 Bulletin 2000/05**

(51) Int. Cl.⁷: **G01R 19/257**, G01N 33/487,
A61B 5/00, G01K 7/24

(21) Numéro de dépôt: **94108903.9**

(22) Date de dépôt: **10.06.1994**

(54) **Circuit de test et procédé pour déterminer de façon ampérométrique le courant traversant un capteur**

Schaltungsanordnung und Verfahren zur Bestimmung des Stroms durch einen Sensor

Testing circuit and method of determining the current flowing through a sensor

(84) Etats contractants désignés:
**CH DE ES FR GB IT LI NL SE**

(30) Priorité: **22.06.1993 FR 9307674**

(43) Date de publication de la demande:
**28.12.1994 Bulletin 1994/52**

(73) Titulaire: **ASULAB S.A.**
**CH-2501 Bienne (CH)**

(72) Inventeur: **Wiget, Fridolin**
**CH-2000 Neuchâtel (CH)**

(74) Mandataire: **Caron, Gérard et al**
**ICB**
**Ingénieurs Conseils en Brevets SA**
**Rue des Sors 7**
**2074 Marin (CH)**

(56) Documents cités:
**EP-A- 0 471 986        DE-A- 2 200 119**
**DE-A- 2 826 723        US-A- 4 215 336**
**US-A- 4 420 564**

• **MESSEN + PRUFEN, no.4, Avril 1979, BAD
WORISHOFEN DE pages 255 - 258 ALBERT
HAUG 'Temperaturmessung mit linearisierten
NTC-Netzwerken und Umsetzung in
Impulsfolgen'**

**Description**

L'invention concerne des circuits ampérométriques et des procédés d'analyse ampérométrique et plus particulièrement des circuits de test et des procédés d'analyse pour déterminer de façon ampérométrique le courant traversant un capteur.

L'invention peut être utilisée dans le cadre de l'analyse ampérométrique utilisant un capteur électroanalytique jetable pour la détermination quantitative de composés biologiques, tels que le glucose, dans des fluides corporels. L'invention sera décrite ci-après en liaison avec cet exemple d'application, mais on comprendra que cette invention n'est bien entendu pas limitée à cette application.

Le diabète est une maladie du métabolisme qui est caractérisée par une production d'insuline insuffisante par le pancréas, ce qui conduit à des taux anormaux de glucose dans le sang. Le taux de glucose dans le sang du patient peut être maintenu à un niveau correct par un contrôle strict de son régime alimentaire et par des injections quotidiennes d'insuline. Toutefois, le taux de glucose dans le sang du patient doit être contrôlé de façon soigneuse soit par des analyses cliniques, soit par des analyses quotidiennes que le patient peut faire en mettant en oeuvre des procédés relativement simples.

Un tel procédé de contrôle du taux de glucose dans le sang d'un patient consiste à utiliser des capteurs comprenant au moins une électrode de référence et une électrode de travail revêtues d'un mélange d'une enzyme catalytiquement active et d'un composé médiateur l'ensemble pouvant être le cas échéant revêtu d'une membrane de maintien perméable. Quand un tel capteur est mis en contact avec un échantillon de sang contenant une substance avec laquelle l'enzyme a un effet catalytique, le composé médiateur transfère des charges vers l'électrode. La mesure des charges transférées à un certain temps bien déterminé après l'instant de l'application d'une tension constante aux bornes du capteur s'est révélée être proportionnelle à la concentration de glucose dans l'échantillon de sang.

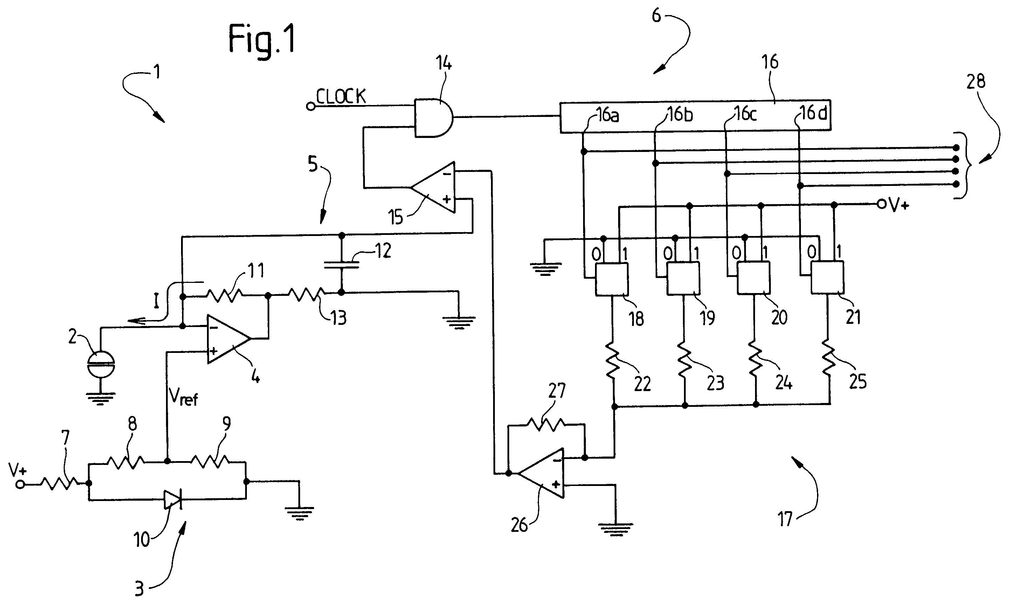

La figure 1 montre un circuit de test 1 existant permettant de mesurer le courant traversant un tel capteur 2. Le circuit de test 1 comprend une source de tension de référence 3, un amplificateur opérationnel 4, un filtre passe-bas 5 et un convertisseur analogique/numérique 6. La source de tension de référence 3 comprend trois résistances 7, 8 et 9 et une diode 10. La résistance 7 est reliée par une extrémité à une tension d'alimentation V+ et par une autre extrémité à l'anode de la diode 10. La cathode de la diode 10 est reliée à la masse tandis que les résistances 8 et 9, branchées en série l'une avec l'autre, sont reliées en parallèle avec la diode 10. La diode 10 est donc conductrice, et les résistances 8 et 9 agissent comme diviseur de la tension aux bornes de cette diode 10 afin de fournir une tension de référence $V_{ref}$ de 300 mV à l'entrée non-inverseuse de l'amplificateur opérationnel 4.

Une électrode du capteur 2 est reliée à l'entrée inverseuse de l'amplificateur opérationnel 4 tandis que son autre électrode est reliée à la masse. Une résistance de contre-réaction 11 ayant une valeur $R_{11}$ est reliée entre la sortie et l'entrée inverseuse de l'amplificateur opérationnel 4. Le courant I circulant dans la résistance 11 est ainsi égal à $V_{ref}/R_{11}$. En raison de la masse virtuelle existant entre les entrées inverseuse et non inverseuse de l'amplificateur opérationnel 4, le courant I circulant à travers la résistance 11 circule également à travers le capteur 2. Connaissant la valeur $R_{11}$ de la résistance 11, la valeur du courant I circulant à travers le capteur 2 peut être déterminée en mesurant la chute de tension aux bornes de la résistance 11.

Le filtre passe-bas 5 comprend un condensateur 12 et une résistance 13 qui sont branchés en série l'un avec l'autre et reliés en parallèle avec la résistance 11 pour éliminer le bruit ou toute autre interférence du signal de tension aux bornes de la résistance 11.

Le convertisseur analogique/numérique 6 comprend une porte ET 14, un comparateur 15, un compteur binaire 16 et un convertisseur numérique/analogique 17. La tension présente aux bornes du condensateur 12 est appliquée sur l'entrée non-inverseuse du comparateur 15 tandis que la sortie du comparateur 15 est reliée à une entrée de la porte ET 14. Un signal d'horloge, désigné par CLOCK, est fourni sur l'autre entrée de cette porte ET 14. Le compteur 16 compte des impulsions de sortie reçues de la porte ET 14, le nombre d'impulsions comptées étant représenté en binaire par les états logiques des signaux présents sur ses sorties 16a, 16b, 16c et 16d. Dans ce circuit, l'état de la sortie 16a représente le bit de poids le plus fort et l'état de la sortie 16d représente le bit de poids le plus faible.

Le convertisseur numérique analogique 17 comprend quatre commutateurs 18, 19, 20 et 21 ayant chacun une entrée de commande reliée à l'une des sorties 16a à 16d du compteur 16 et deux entrées respectivement reliées à la masse et à la tension d'alimentation V+. Chacun de ces commutateurs 18 et 21 est agencé de manière que, selon le niveau logique haut ou bas de la sortie 16a à 16d auquel son entrée de commande est reliée, sa sortie est reliée à la tension d'alimentation V+ ou à la masse.

La sortie de chacun des commutateurs 18 et 21 est reliée par l'intermédiaire d'une résistance 22, 23, 24 et, respectivement 25 à l'entrée inverseuse d'un amplificateur opérationnel 26. L'entrée non inverseuse de cet amplificateur opérationnel 26 est reliée à la masse, et sa sortie est reliée, d'une part, à son entrée inverseuse par l'intermédiaire d'une résistance de contre-réaction 27 et, d'autre part, à l'entrée inverseuse du comparateur 15. Les résistances 22, 23, 24 et 25 ont des valeurs respectives de R, 2R, 4R et 8R de sorte qu'un niveau logique haut sur les sorties 16a, 16b, 16c et 16d provoquent respectivement l'application d'une tension de 8V, 4V, 2V et V sur l'entrée inverseuse de l'amplificateur opérationnel 26 où V est la valeur de la tension appliquée à cette entrée inverseuse de l'amplificateur opérationnel 26 lorsque seule la sortie 16d du compteur 16 est au niveau logique haut. Une tension correspondant à la somme des tensions appliquées sur sa sortie inverseuse est fournie sur la sortie de l'amplificateur opérationnel 26. Cette tension est comparée par le comparateur 15 à la tension aux bornes du condensateur 12.

Initialement, le compteur 12 est mis à zéro et chacune de ses sorties 16a, 16b, 16c et 16d est au niveau logique bas. La somme des tensions appliquées à l'entrée inverseuse de l'amplificateur opérationnel 26 et la tension sur l'entrée inverseuse du comparateur 15 sont donc de zéro volt. Dans ces conditions, la sortie du comparateur 15 est au niveau logique haut et la porte ET 14 transmet le signal d'horloge CLOCK au compteur 16. Le compteur 16 enregistre le nombre d'impulsions d'horloge reçues de la porte ET 14. Le nombre binaire sur les sorties 16a, 16b, 16c et 16d représentant le nombre d'impulsions comptées, qui augmente linéairement en fonction du temps, est utilisé comme entrée du convertisseur numérique/analogique 17. La tension de sortie du convertisseur numérique/analogique 17, qui augmente par pas a, à chaque instant, une valeur correspondant à la somme des tensions appliquée sur l'entrée inverseuse de l'amplificateur opérationnel 26.

Tant que la tension aux bornes du condensateur 12 est plus grande que la tension de la sortie de l'amplificateur opérationnel 26, la sortie du comparateur 15 est au niveau logique haut et la porte ET 14 transmet les impulsions du signal d'horloge CLOCK au compteur 16. Quand la tension à la sortie de l'amplificateur opérationnel 26 dépasse la tension aux bornes du condensateur 12, la sortie du comparateur 15 passe au niveau logique bas, ce qui bloque la porte ET 14 et interrompt le comptage des impulsions du signal d'horloge CLOCK. A cet instant, la tension aux bornes du condensateur 12 et la tension sur la sortie de l'amplificateur opérationnel 26 sont approximativement égales, des sorties 16a, 16b, 16c et 16d du compteur 16 représentent un nombre un mot binaire 28 qui est une mesure de la tension aux bornes du condensateur 12. Comme la valeur de la résistance 11 est connue, ce nombre binaire 28 est également représentatif de la valeur du courant I traversant le capteur 2.

Le circuit de test 1 montré à la figure 1 est de type analogique et nécessite l'utilisation de deux amplificateurs opérationnels 4 et 26, en plus des nombreux autres éléments de circuit décrits ci-dessus, pour produire un signal de sortie numérique représentatif de la résistance du capteur 2. Afin de mesurer de façon précise, le taux de glucose dans l'échantillon de sang déposé sur le capteur, les amplificateurs opérationnels 4 et 26 doivent avoir d'excellentes performances en courant continu, pour des petits signaux et en régime transitoire et doivent avoir des caractéristiques de transfert très linéaires. Afin d'obtenir de telles performances, il est fréquemment nécessaire d'utiliser vingt transistors ou plus ainsi que plusieurs résistances et plusieurs condensateurs pour réaliser chacun des amplificateurs opérationnels 4 et 26. De tels amplificateurs présentent toutefois l'inconvénient d'être difficiles à réaliser de façon précise sous la forme d'un circuit intégré.

Le circuit de test de l'art antérieur qui vient d'être schématiquement décrit correspond par exemple à une partie du circuit divulgué dans le document EP 0 351 892. Dans le document EP 0 471 986, un circuit de test comprenant une source de courant et des moyens de commutation pour commander de façon sélective ladite source de courant permet grâce à un microprocesseur et à un circuit complexe de différencier un capteur de test d'un capteur de calibration et de sélectionner une courbe de calibration.

Un but de la présente invention est de fournir un circuit de test pour déterminer de façon ampérométrique l'intensité du courant traversant un capteur qui pallie les inconvénients de l'art antérieur.

A cet effet, l'invention a donc pour objet un circuit de test pour la détermination ampérométrique du courant traversant un capteur, dans lequel une source de courant est commandée sélectivement par des moyens de commutation pour faire circuler ou interrompre un courant continu à travers ledit capteur, caractérisé en ce qu'il comprend en outre des moyens de comparaison pour comparer la différence de potentiel aux bornes dudit capteur à une tension de référence et pour produire un signal de commande ayant un premier niveau logique quand la différence de potentiel est inférieure à la tension de référence et un deuxième niveau logique quand ladite différence de potentiel est supérieure à ladite tension de référence, des moyens de commande assujettis à un signal d'horloge (CLOCK) ayant un nombre déterminé de cycle par seconde pour fournir un signal de commutation ayant ledit premier ou ledit deuxième niveau logique selon que ledit signal de commande a ledit premier ou ledit deuxième niveau logique, lesdits moyens de commutation faisant circuler ledit courant continu quand ledit signal de commutation a ledit premier niveau logique, et des moyens d'horloge pour mesurer le temps cumulé passé audit premier au niveau logique par ledit signal de commutation pendant une période de mesure afin de fournir un signal de sortie représentatif de la valeur moyenne de ladite intensité du courant traversant ledit capteur.

On fournit ainsi un circuit de test dans lequel le nombre de composants est réduit, ce circuit de test ne nécessitant par ailleurs pas les circuits complexes et très précis des circuits de test de l'art antérieur. Le circuit de test de la présente invention est par conséquent plus facilement réalisable sous la forme d'un circuit intégré.

Un autre but de la présente invention est de fournir un procédé pour déterminer de façon ampérométrique l'intensité du courant traversant un capteur en utilisant un circuit de test ayant une source de courant, des moyens de commutation, des moyens de comparaison, des moyens de commande et des moyens d'horloge tels que ceux décrits ci-dessus, caractérisé en ce qu'il comprend les étapes de :

(a) remplacer ledit capteur par un élément de calibration de résistance connue,

(b) mesurer un premier temps cumulé passé par ledit signal de commutation audit premier niveau pendant une période de mesure afin de déterminer un facteur de calibration,

(c) remplacer ledit élément de calibration par ledit capteur,

(d) mesurer un deuxième temps cumulé passé par ledit signal de commutation audit premier niveau logique pendant ladite période de mesure,

(e) multiplier ledit deuxième temps cumulé par ledit facteur de calibration afin de fournir un signal de sortie représentatif de la valeur moyenne de l'intensité du courant traversant ledit capteur.

De cette manière, le circuit de test peut être calibré de sorte que son signal de sortie est indépendant de la valeur réelle du courant fourni par la source de courant continu.

La description qui suit se réfère plus en détail aux différentes caractéristiques de la présente invention. Pour faciliter la compréhension de l'invention, on fera référence, dans cette description, au dessin annexé dans lequel :

La figure 1 déjà décrite, est un schéma simplifié d'un circuit de test de l'art antérieur;

La figure 2 est un schéma simplifié d'un mode de réalisation du circuit de test selon la présente invention donné à titre d'exemple non limitatif; et

La figure 3 est un chronogramme montrant l'interdépendance entre différents signaux mesurés dans le circuit de la figure 2.

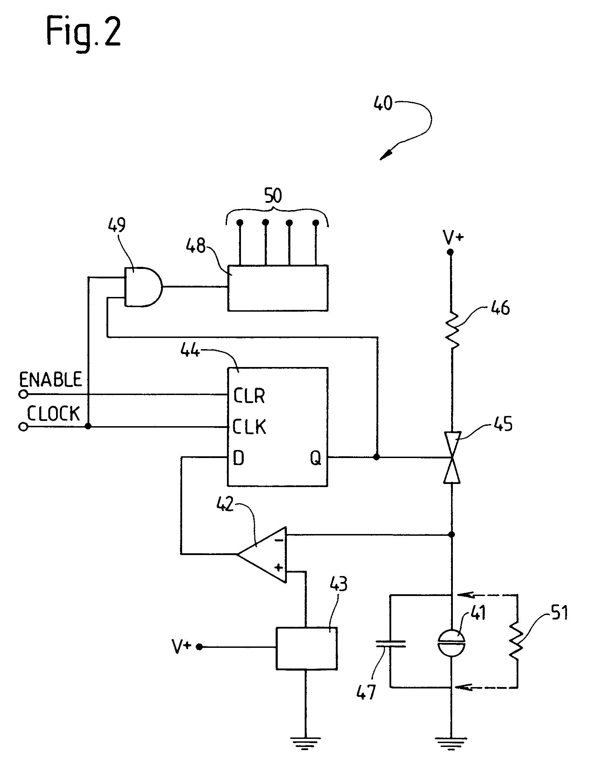

En se référant maintenant à la figure 2, on voit un circuit de test, désigné par la référence générale 40, pour déterminer de façon ampérométrique le courant traversant un capteur 41. Le circuit 40 comprend un comparateur 42, une source de tension de référence 43, une bascule D 44, une porte de transmission analogique 45, une résistance 46, un condensateur 47, un compteur 48 et une porte ET 49. La résistance 46 est reliée par une de ses extrémités à une tension d'alimentation V+ et par son autre extrémité à une électrode du capteur 41 par l'intermédiaire de la porte analogique 45. L'autre électrode du capteur 41 est reliée à la masse. Le condensateur 47 est relié en parallèle aux bornes du capteur 41. Quand la porte analogique 45 est conductrice, un courant circule à travers le capteur 41 et à travers le condensateur 47.

La différence de potentiel $V_{BS}$ aux bornes du capteur 41 est comparée par le comparateur 42 à une tension de référence, par exemple de 300 mV, fournie par la source de tension de référence 43. La sortie du comparateur 42 est au niveau logique haut quand la différence de potentiel $V_{BS}$ aux bornes du capteur 41 est inférieure à la tension de référence de 300 mV et la sortie du comparateur 42 est au niveau logique bas quand la différence de potentiel aux bornes du capteur 41 est supérieure à la tension de référence de 300 mV.

La sortie du comparateur 42 est reliée à l'entrée D de la bascule D 44. Un signal d'horloge CLOCK, comprenant une série d'impulsions régulièrement espacées dans le temps et ayant, par exemple, une fréquence de 32768 impulsions par seconde, est fourni à l'entrée d'horloge CLOCK de la bascule D 44. La sortie Q de la bascule D 44 prend, à la fin chaque impulsion d'horloge CLOCK le niveau logique haut ou bas que le signal fourni à l'entrée D avait au début de cette même impulsion d'horloge. Le niveau de la sortie Q est maintenu entre deux impulsions d'horloge consécutives.

La bascule D 44 a une entrée de remise à zéro sur laquelle est fourni un signal d'activation ENABLE par un circuit de contrôle qui n'est pas montré sur la figure 2. Quand le signal d'activation est au niveau logique bas, la sortie Q de la bascule D 44 est maintenue au niveau logique bas. Inversement, quand le signal d'activation ENABLE est au niveau logique haut, l'état du signal présent à l'entrée D de la bascule D 44 au début de chaque impulsion d'horloge est transféré sur sa sortie Q à la fin de cette impulsion d'horloge.

La sortie Q de la bascule 44 est reliée à la porte analogique 45 afin de commander le fonctionnement de celle-ci. La porte analogique 45 est ouverte et autorise la circulation du courant à travers le capteur 41 quand la sortie Q de la bascule 44 est au niveau logique haut. Dans cet état, la résistance de la porte analogique 45 est sensiblement inférieure à celle de la résistance 46. Le courant fourni au capteur 41 est donc déterminé essentiellement par la valeur de la tension V+ et de la résistance 46.

Quand la sortie Q de la bascule 44 est au niveau logique bas, la porte analogique 45 est bloquée et empêche la circulation du courant à travers le capteur 41. De cette manière, le fonctionnement de la porte analogique 45 est commandé de sorte qu'elle est soit conductrice, soit bloquée pendant au moins la durée d'un cycle d'horloge. On voit que la tension V+ et la résistance 46 forment une source de courant qui est commandée, par l'intermédiaire de la porte 45, par le signal présent à la sortie Q de la bascule 44. L'utilisation de la bascule D 44 empêche le circuit de test 40 d'entrer dans une condition de basculement en série dans laquelle la sortie du comparateur 42 et l'état de la porte analogique 45 oscillent rapidement entre leurs deux états et dans laquelle ce circuit de test 40 ne donnerait pas de résultat utilisable. On comprendra que d'autres moyens tels qu'une bascule R-S ou d'autres circuits appropriés peuvent être utilisés pour commander le fonctionnement des moyens de commutation de la source de courant.

La sortie Q de la bascule D 44 et le signal d'horloge CLOCK sont associés de façon logique par la porte ET 49, dont la sortie est reliée au compteur 48. Le compteur 48 compte ainsi le nombre de cycles d'horloge quand la sortie Q de la bascule D est au niveau logique haut. La sortie 50 du compteur 48 fournit un nombre binaire du temps total pendant lequel cette sortie D est au niveau logique haut. Ce temps total est représentatif de la résistance du capteur 41 comme cela apparaîtra ci-après.

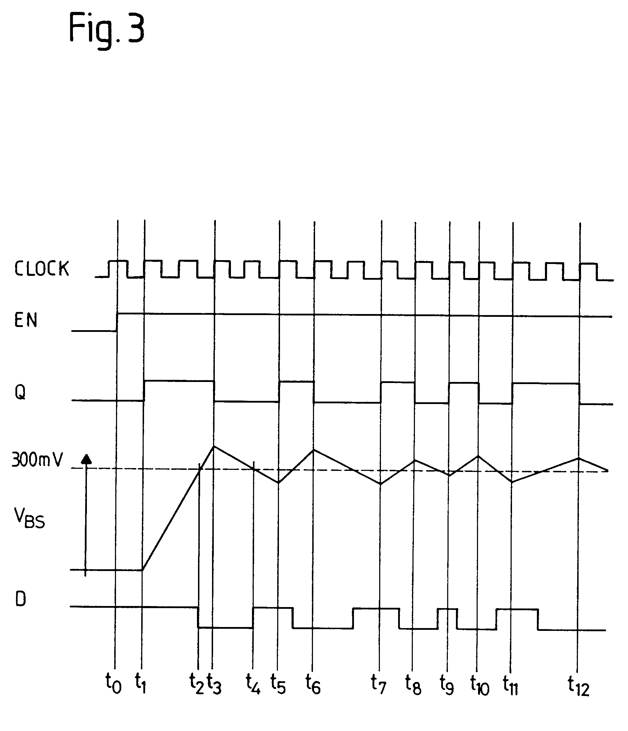

Le fonctionnement du circuit de test 40 va maintenant être expliqué en liaison avec la figure 3 qui montre un chronogramme du signal d'horloge CLOCK, du signal d'activation ENABLE, de la sortie Q de la bascule 44, de la tension $V_{BS}$ aux bornes du capteur 41 et de l'entrée D de la bascule qui ont été décrits en liaison avec la figure 2. A l'instant $t_0$, le signal d'activation ENABLE passe du niveau logique bas au niveau logique haut. Quand la porte analogique 45 est fermée, aucun courant ne circule à travers le capteur 41 et la différence de potentiel $V_{BS}$ aux bornes de ce dernier est de zéro volt. Dans ces conditions, la sortie du comparateur 42 est au niveau logique haut.

A la fin de l'impulsion d'horloge suivante, à l'instant $t_1$, le niveau logique haut de l'entrée D est transféré à la sortie Q, et la porte analogique 45 devient conductrice. Du courant circule alors à travers la résistance 46, le condensateur 47 et le capteur 41. Le condensateur 47 se charge, et la différence de potentiel $V_{BS}$ à ses bornes et à celles du capteur 41 augmente en fonction du temps. Tant que cette différence de potentiel $V_{BS}$ reste inférieure à la tension de référence de 300 mV, l'entrée D reste au niveau logique haut de même que la sortie Q, et la porte analogique 45 reste conductrice. En outre, pendant ce temps, le compteur 48 compte les impulsions d'horloge qui lui sont transmises par la porte ET 49.

Dans d'autres modes de réalisation de la présente invention, le condensateur 47 peut être omis du circuit de test 40, l'augmentation de la différence de potentiel aux bornes du capteur 41 au cours du temps étant alors due à la capacité interne du capteur 41 lui-même.

A l'instant $t_2$, la différence de potentiel $V_{BS}$ aux bornes du capteur 41 atteint la valeur de 300 mV. La sortie du comparateur 42 et par conséquent l'entrée D passent au niveau logique bas. A la fin de l'impulsion d'horloge suivante, à l'instant $t_3$, la sortie Q passe au niveau logique bas, bloquant ainsi la porte analogique 45 et empêchant le courant de circuler à travers le capteur 41. En outre, la porte ET 49 bloque la transmission des impulsions d'horloge vers le compteur 48 qui s'arrête temporairement de compter.

Comme aucun courant ne circule plus à partir de la borne d'alimentation V+ et à travers la résistance 46, le condensateur 47 se décharge au cours du temps jusqu'à ce que la différence de potentiel aux bornes du capteur 41 tombe en dessous de la tension de référence de 300 mV, à un instant $t_4$. La sortie du comparateur et l'entrée D passent alors du niveau logique bas au niveau logique haut. A la fin de l'impulsion d'horloge suivante, à l'instant $t_5$, la sortie Q passe au niveau logique haut ce qui rend la porte analogique 45 conductrice et permet à nouveau au courant de circuler à travers la résistance 46 vers le condensateur 47 et vers le capteur 41. La porte ET 49 peut à nouveau transmettre le signal d'horloge CLOCK au compteur 48, qui recommence alors à compter. Le condensateur 47 est à nouveau chargé par le courant fourni par la borne d'alimentation V+ à travers la résistance 46, de sorte que la différence de potentiel $V_{BS}$ aux bornes du capteur 41 augmente à nouveau.

Ce processus continue, la porte analogique 45 passant alternativement de son état bloqué à son état conducteur et vice-versa à des instants $t_6$ à $t_{12}$ comme cela est représenté à la figure 3. La différence de potentiel $V_{BS}$ aux bornes du capteur 41 oscille donc autour de la valeur de 300 mV.

Pendant le temps au cours duquel la porte analogique 45 est conductrice, le courant $I_{BS}$ circulant à travers la résistance 46, après l'instant $t_0$, est déterminé par

$$I_{BS} = (V+ - V_{ref})/R_{46}$$

où $V_{ref}$ est la tension de référence de 300 mV et $R_{46}$ est la valeur de la résistance 46. Cette valeur $R_{46}$ est invariable de sorte que la tension d'alimentation V+ et la résistance 46 forment effectivement une source de courant constant alimentant le capteur 41 en courant constant. Le fonctionnement de cette source de courant constant est commandé par la porte analogique 45. Dans d'autres modes de réalisation de l'invention, d'autres sources de courant constant commutables peuvent être utilisées à la place de celle montrée à la figure 2 comme cela apparaîtra clairement à l'homme de métier. En outre, les moyens de commutation pour mettre en fonction de façon sélective la source de courant constant peuvent être réalisés autrement que par la porte analogique 45.

La proportion du temps pendant lequel la porte analogique 46 a été ouverte peut être déterminée par le rapport NQ1/(NQ1 + NQ0) où NQ1 est le nombre cumulé d'impulsions d'horloge qui ont été comptées par le compteur 48 pendant la période de mesure, ce nombre NQ1 étant donc représentatif du temps cumulé pendant lequel la porte analogique 45 était ouverte au cours de cette période de mesure et NQ0 est le nombre d'impulsions d'horloge qui n'ont pas été comptées par le compteur 48 pendant cette période de mesure, ce nombre NQ0 étant donc représentatif du temps cumulé pendant lequel la porte analogique 45 était bloquée au cours de la période de mesure. La somme des nombres NQ1 et NQ0 est évidemment représentative de la durée de la période de mesure.

Le courant moyen $I_{BS}$ave circulant à travers le capteur 41 et le condensateur 47 pendant la période de mesure est ainsi donné par

$$I_{BS}ave = [(V+ - V_{ref})/R_{46}] * [NQ1/(NQ1 + NQ0)]$$

Comme les valeurs de V+, $V_{ref}$, $R_{46}$ et (NQ1 + NQ0) sont prédéterminées, le nombre NQ1 est représentatif du courant moyen $I_{BS}ave$ circulant à travers le capteur 41 pendant la période de mesure.

De préférence, le circuit de test 40 montré à la figure 2 peut être calibré pour prendre en compte les variations éventuelles de la valeur du courant continu dues à des variations de la valeur de V+ et/ou de la valeur $R_{46}$ de la résistance 46 au cours du temps. Par exemple, si la tension V+ est fournie par une source de tension telle qu'une pile, on sait que sa valeur réelle diminuera de façon importante au cours du temps. De façon similaire, la valeur précise $R_{46}$ de la résistance 46 peut être différente d'un circuit à l'autre à cause des tolérances de fabrication qui peuvent être de plus ou moins 5%, voire même plus. Même si ces valeurs $R_{46}$ et V+ ne peuvent pas être connues avec précision, elles sont toutefois stables au cours d'une période de quelques heures. Au cours de la période de mesure, qui ne dure que quelques dizaines de secondes, ces valeurs peuvent donc être considérées comme invariables.

Afin de calibrer le circuit de test 40 pour éliminer l'effet des variations des valeurs V+ et $R_{46}$, le capteur 41 peut être remplacé par une résistance de précision 51 ayant une valeur $R_{cal}$. Une telle résistance peut être, par exemple, une résistance bobinée ayant une tolérance de ±0,05% ou encore meilleure. Le courant moyen $I_{cal}ave$ circulant à travers la résistance 51 est déterminé par

$$I_{cal}ave = [(V+ - V_{ref})/R_{46}] * [NQ1cal/(NQ1cal + NQ0cal)]$$

où $NQ1_{cal}$ est le nombre cumulé d'impulsions d'horloge comptées pendant que la porte analogique 45 est conductrice au cours d'une période de mesure et $NQ0_{cal}$ est le nombre d'impulsions d'horloge se produisant pendant que la porte analogique 45 est bloquée au cours de la période de mesure. Il en résulte ainsi que

$$(V+ - V_{ref})/R_{46} = (V_{ref}*NQcal/(R_{cal}*NQ1cal) = Xcal$$

ou

$$NQcal = (NQ1cal + NQ0cal)$$

et $X_{cal}$ est le facteur de calibration du circuit de test 40. Comme les valeurs de $V_{ref}$ et $R_{cal}$ sont connues, le facteur de calibration $X_{cal}$ peut être obtenu directement à partir de la sortie du compteur 48 pour une période de mesure correspondant à $NQ_{cal}$ impulsions d'horloge.

Après la détermination du facteur de calibration $X_{cal}$, la résistance de précision 51 est remplacée par le capteur 41 et le courant moyen $I_{BS}ave$ circulant à travers le capteur 41 est mesuré comme cela est décrit ci-dessus. La valeur réelle de la résistance du capteur 41 à laquelle le nombre binaire 50 correspond est obtenue en divisant le nombre binaire 50 par le facteur de calibration $X_{cal}$. Ceci peut être compris en considérant que le courant moyen $I_{BS}ave$ circulant à travers le capteur 41 est déterminé par

$$I_{BS}ave = [(V+ - V_{ref})/R_{46}]*(NQ1mes/NQmes) =$$
$$Xcal*(NQ1mes/NQmes)$$

où $NQ1_{mes}$ est le nombre d'impulsions d'horloge comptées, une fois que la résistance de précision 51 a été remplacée par le capteur 41 pendant le temps cumulé où la porte analogique 45 est conductrice au cours de la période de mesure, et $NQ0_{mes}$ est le nombre d'impulsions d'horloge se produisant pendant que la porte analogique 45 est bloquée. Le courant moyen $I_{BS}ave$ circulant à travers le capteur 41 peut ainsi être mesuré d'une façon indépendante de toute variation des valeurs V+ et $R_{46}$.

Si la valeur $R_{46}$ de la résistance 46 est connue avec précision, l'étape de calibration décrite ci-dessus dans laquelle Xcal est déterminé, permet de déterminer la valeur réelle de V+ à partir d'un calcul donné par l'équation suivante :

$$V+ = (Xcal*R_{46}) - V_{ref}$$

Cette valeur peut aussi être utilisée pour détecter la fin de la vie de la pile, c'est-à-dire le moment où la valeur V+ devient inférieure à un seuil déterminé, ce qui indique que la pile doit être remplacée.

Le circuit de test 40 peut aussi être utilisé dans des applications nécessitant la mesure de températures. Un capteur à coefficient de température négatif (NTC) ayant une résistance qui varie de façon connue avec la température peut être utilisé à la place du capteur 41. Le nombre binaire 50 présent à la sortie du compteur 48 est dans ce cas représentatif de la résistance du capteur NTC et donc de la température ambiante autour du capteur NTC.

Alors que la présente invention vient d'être décrite principalement en liaison avec la mesure d'un taux de glucose dans le sang, le circuit de test et le procédé de détermination ampérométrique du courant circulant à travers un capteur utilisant le circuit de test de la présente invention peuvent également être utilisés en liaison avec la détermination quantitative d'autres substances biologiques importantes telles que le TSH, le T4, des hormones telles que le HCG, des glucosides cardiaques tels que la digoxine, des antiarythmiques tels que la lidocaïne, des antiépileptiques tels que le phénobarbital, des antibiotiques tels que la gentamycine, le cholestérol, et des substances non thérapeutiques et analogues.

Enfin, on comprendra que différentes modifications et ou additions peuvent être apportées au circuit de test et au procédé de détermination ampérométrique du courant circulant à travers un capteur utilisant ce circuit de test sans sortir du cadre de la présente invention définie par les revendications annexées.

## Revendications

1. Circuit de test pour la détermination ampérométrique du courant traversant un capteur (41), dans lequel une source de courant (V+, 46) est commandée sélectivement par des moyens de commutation (45) pour faire circuler ou interrompre un courant continu à travers ledit capteur, caractérisé en ce qu'il comprend en outre :

   - des moyens de comparaison (42) pour comparer la différence de potentiel ($V_{BS}$) aux bornes dudit capteur à une tension de référence ($V_{ref}$) et pour produire un signal de commande (D) ayant un premier niveau logique quand ladite différence de potentiel ($V_{BS}$) est inférieure à la tension de référence ($V_{ref}$) et un deuxième niveau logique quand ladite différence de potentiel est supérieure à ladite tension de référence ($V_{ref}$),
   - des moyens de commande (44) assujettis à un signal d'horloge (CLOCK) ayant un nombre déterminé de cycles par seconde pour fournir un signal de commutation (Q) prenant ledit premier niveau logique en réponse audit signal de commande (D) ayant ledit premier niveau logique et ledit deuxième niveau logique en réponse audit signal de commande (D) ayant ledit deuxième niveau logique, lesdits moyens de commutation (45) faisant circuler ledit courant continu quand ledit signal de commutation (Q) est audit premier niveau logique, et
   - des moyens d'horloge (48, 49) pour mesurer le temps cumulé passé audit premier niveau logique par ledit signal de commutation durant une période de mesure afin de fournir un signal de sortie (50) représentatif d'une valeur moyenne ($I_{BS}$ave) du courant traversant ledit capteur (41).

2. Circuit de test selon la revendication 1, caractérisé en ce que lesdits moyens d'horloge comprennent :

   - un circuit de comptage (48) commandé par une porte ET (49) recevant ses signaux des moyens de commande (44) et du signal d'horloge (CLOCK) pour compter le nombre de cycles pendant lesquels ledit signal de commutation (Q) est à son premier niveau logique au cours de ladite période de mesure.

3. Circuit de test selon la revendication 2, caractérisé en ce que ladite source de courant comprend

   - une source de tension (V+) pour fournir une tension continue constante,
   - un élément résistif (46) relié entre ladite source de tension (V+) et ledit capteur (41), lesdits moyens de commutation (45) étant commandés de façon sélective afin de maintenir la différence de potentiel ($V_{BS}$) aux bornes dudit capteur (41) à un niveau sensiblement constant et ainsi fournir un courant sensiblement constant ($I_{BS}$) audit capteur (41) quand lesdits moyens de commutation (45) sont activés.

**4.** Circuit de test selon la revendication 3, caractérisé en ce que lesdits moyens de commutation (45) sont reliés en série avec ledit élément résistif (46).

**5.** Circuit de test selon la revendication 4, caractérisé en ce que lesdits moyens de commutation (45) présentent une résistance intérieure sensiblement inférieure audit élément résistif (46).

**6.** Circuit de test selon l'une quelconque des revendications précédentes, caractérisé en ce que lesdits moyens de commande (44) comprennent une bascule assujettie au signal d'horloge (CLOCK) et ayant une entrée (D) et une sortie (Q), ledit signal de commande étant fourni à ladite entrée (D) et ledit signal de commutation étant fourni par ladite sortie (Q).

**7.** Circuit de test selon la revendication 6, caractérisé en ce que lesdits moyens d'horloge (48, 49) comptent le nombre de cycles d'horloge, au cours de ladite période de mesure, pendant lesquels ladite sortie (Q) est audit premier niveau logique.

**8.** Circuit de test selon l'une quelconque des revendications précédentes, caractérisé en ce qu'il comprend en outre un élément capacitif (47) relié en parallèle avec ledit capteur (41).

**9.** Procédé de détermination ampérométrique du courant circulant à travers un capteur utilisant un circuit de test selon l'une quelconque des revendications précédentes, caractérisé en ce qu'il comprend les opérations suivantes :

(a) remplacer ledit capteur (41) par un élément de calibration (51) de résistance connue,
(b) mesurer un premier temps cumulé (NQ1$_{cal}$) passé par ledit signal de commutation (Q) audit premier niveau logique pendant une période de mesure afin de déterminer un facteur de calibration (X$_{cal}$),
(c) remplacer ledit élément de calibration (51) par ledit capteur (41),
(d) mesurer un deuxième temps cumulé (NQ1$_{mes}$) passé par ledit signal de commutation (Q) audit premier niveau logique pendant ladite période de mesure,
(e) multiplier ledit deuxième temps cumulé (NQ1$_{mes}$) par ledit facteur de calibration (X$_{cal}$) afin de fournir un signal de sortie représentatif du courant moyen (I$_{BS}$ave) traversant ledit capteur (41) pendant ladite période de mesure.

**10.** Procédé selon la revendication 9 utilisant un circuit de test selon la revendication 2, caractérisé en ce que les étapes (b) et (d) comprennent le comptage du nombre de cycles, au cours de ladite période de mesure, pendant lesquels le signal de commutation (Q) est audit premier niveau logique.

**11.** Procédé selon la revendication 9 utilisant un circuit de test selon la revendication 7, caractérisé en ce que les étapes (b) et (d) comprennent le comptage du nombre de cycles d'horloge pendant lesquels ladite sortie (Q) est audit premier niveau logique au cours de ladite période de mesure.

**Claims**

**1.** Diagnostic circuit for amperometrically determining the current passing through a sensor (41), in which a current source (V+, 46) is selectively controlled by switching means (45) for passing or interrupting a constant current through said sensor, characterized in that it further comprises :

- comparing means (42) for comparing the potential difference (V$_{BS}$) across said sensor to a reference voltage (V$_{ref}$), and producing a control signal (D) having a first logic level when said potential difference is less than said reference voltage (V$_{ref}$) and a second logic level when said potential difference is greater than said reference voltage (V$_{ref}$),
- control means (44) driven by a clock signal (CLOCK) having a known number of cycles per second for providing a switching signal (Q) having said first logic level in response to said control signal (D) having said first logic level and said second logic level in response to said control signal (D) having said second logic level, said switching means (45) making said continuous current to circulate when said switching signal (Q) is in said first logic level, and
- timing means (48, 49) for measuring the cumulative time during which said switching signal (Q) has said first logic level during a selected time interval, so as to provide an output signal (50) indicative of a mean value of current (I$_{bs}$ave) passing through said sensor (41).

2. Diagnostic circuit according to claim 1, characterized in that said timing means comprises :

- a counting circuit (48) controlled by an output AND (49) receiving its signals from control means (44) and by a clock signal (CLOCK) for counting the number of cycles during which said switching signal (Q) has said first logic level during said time interval.

3. Diagnostic circuit according to claim 2, characterized in that said current source comprises :

- a voltage source (V+) for supplying a constant DC voltage,
- a resistance element (46) connected between said voltage source (V+) and said sensor (41), said switching means (45) being selectively controlled so as to maintain the potential difference ($V_{BS}$) across said sensor terminals (41) at a substantially constant level and thus supply a substantially constant current ($I_{BS}$) to said sensor (41) when said switching means (45) is operated.

4. Diagnostic circuit according to claim 3, characterized in that said switching means (45) is connected in series with said resistance element (46).

5. Diagnostic circuit according to claim 4, characterized in that said switching means (45) has an internal resistance substantially less than said resistance element (46).

6. Diagnostic circuit according to any one of the preceding claims, characterized in that said control means comprises a latch driven by clock signal (CLOCK) and having an input (D) and an output (Q), said control signal being supplied to said input (D) and said switching signal being supplied by said output (Q).

7. Diagnostic circuit according to claim 6, characterized in that said timing means (48,49) counts the number of clock cycles, during said time interval, when said output (Q) is at said first logic level

8. Diagnostic circuit according to any one of the preceding claims, characterized in that it further comprises a capacitive element (47) connected in parallel with said sensor (41).

9. Method of amperometrically determining the current passing through a sensor using a diagnostic circuit according to any one of the preceding claims, characterized in that it comprises the following steps :

(a) replacing said sensor (41) with a calibration element (51) of known resistance,
(b) measuring a first cumulative time ($NQ1_{cal}$) during which said switching signal (Q) is at said first logic level during one time interval so as to determine a calibration factor ($X_{cal}$),
(c) replacing said calibration element (51) with said sensor (41),
(d) measuring a second cumulative time ($NQ1_{mes}$) during which said switching signal is at said first logic level during said time interval,
(e) muliplying said second cumulative time ($NQ1_{mes}$) by said calibration factor ($X_{cal}$) so as to provide an output signal indicative of the mean current ($I_{bs}ave$) passing through said sensor (41) during said time interval.

10. Method according to claim 9 using a diagnostic circuit according to claim 2, characterized in that steps (b) and (d) comprise counting the number of cycles, during said time interval, when said switching signal (Q) is in said first logic level.

11. Method according to claim 9 using a diagnostic circuit according to claim 7, characterized in that steps (b) and (d) comprise counting the number of clock cycles during which said output (Q) is in said first logic level during said time interval.

**Patentansprüche**

1. Testschaltung für die ampèremetrische Bestimmung des durch einen Sensor (41) fließenden Stroms, in der eine Stromquelle (V+, 46) wahlweise durch Umschaltmittel (45) gesteuert wird, um einen Gleichstrom durch den Sensor zu schicken oder zu unterbrechen, dadurch gekennzeichnet, daß sie außerdem umfaßt:

- Vergleichsmittel (42) zum Vergleichen der Potentialdifferenz ($V_{BS}$) an den Anschlüssen des Sensors mit einer Referenzspannung ($V_{ref}$) und zum Erzeugen eines Steuersignals (D), das einen ersten logischen Pegel

EP 0 631 146 B1

besitzt, wenn die Potentialdifferenz ($V_{BS}$) kleiner als die Referenzspannung ($V_{ref}$) ist, und einen zweiten logischen Pegel besitzt, wenn die Potentialdifferenz größer als die Referenzspannung ($V_{ref}$) ist,

- Steuermittel (44), die einem Taktsignal (CLOCK) unterliegen, das eine bestimmte Anzahl von Zyklen pro Sekunde besitzt, um ein Umschaltsignal (Q) zu liefern, das als Antwort auf das Steuersignal (D) mit dem ersten logischen Pegel den ersten logischen Pegel annimmt und als Antwort auf das Steuersignal (D) mit dem zweiten logischen Pegel den zweiten logischen Pegel annimmt, wobei die Umschaltmittel (45) den Gleichstrom liefern, wenn das Umschaltsignal (Q) den ersten logischen Pegel besitzt, und
- Taktgebermittel (48, 49) zum Messen der kumulierten Zeit, in der das Umschaltsignal während einer Meßperiode den ersten logischen Pegel besaß, um ein Ausgangssignal (50) zu liefern, das einen Mittelwert ($I_{BS}$ave) des durch den Sensor fließenden Stroms repräsentiert.

2. Testschaltung nach Anspruch 1, dadurch gekennzeichnet, daß die Taktgebermittel enthalten:

- eine Zählerschaltung (48), die durch ein UND-Gatter (49) gesteuert wird, das Signale von den Steuermitteln (44) und das Taktsignal (CLOCK) empfängt, um die Anzahl von Zyklen zu zählen, in denen das Umschaltsignal (Q) während der Meßperiode seinen ersten logischen Pegel besitzt.

3. Testschaltung nach Anspruch 2, dadurch gekennzeichnet, daß die Stromquelle enthält:

- eine Spannungsquelle (V+) zum Liefern einer konstanten Gleichspannung,
- ein Widerstandselement (46), das zwischen die Spannungsquelle (V+) und den Sensor (41) geschaltet ist, wobei die Umschaltmittel (45) wahlweise gesteuert werden, um die Potentialdifferenz ($V_{BS}$) an den Anschlüssen des Sensors (41) auf einem im wesentlichen konstanten Pegel zu halten und um somit einen im wesentlichen konstanten Strom ($I_{BS}$) an den Sensor (41) zu liefern, wenn die Umschaltmittel (45) aktiv sind.

4. Testschaltung nach Anspruch 3, dadurch gekennzeichnet, daß die Umschaltmittel (45) mit dem Widerstandselement (46) in Reihe geschaltet sind.

5. Testschaltung nach Anspruch 4, dadurch gekennzeichnet, daß die Umschaltmittel (45) einen internen Widerstand aufweisen, der wesentlich kleiner als das Widerstandselement (46) ist.

6. Testschaltung nach irgendeinem der vorangehenden Ansprüche, dadurch gekennzeichnet, daß die Steuermittel (44) eine Kippschaltung enthalten, die einem Taktsignal (CLOCK) zugeordnet ist und einen Eingang (D) sowie einen Ausgang (Q) besitzt, wobei das Steuersignal an den ersten Eingang (D) geliefert und das Umschaltsignal vom Ausgang (Q) geliefert wird.

7. Testschaltung nach Anspruch 6, dadurch gekennzeichnet, daß die Taktgebermittel (48, 49) die Anzahl der Taktzyklen während der Meßperiode, in denen der Ausgang (Q) auf dem ersten logischen Pegel liegt, zählen.

8. Testschaltung nach irgendeinem der vorangehenden Ansprüche, dadurch gekennzeichnet, daß sie außerdem ein kapazitives Element (47) enthält, das zum Sensor (41) parallelgeschaltet ist.

9. Verfahren zur ampèremetrischen Bestimmung des durch einen Sensor fließenden Stroms unter Verwendung einer Testschaltung nach irgendeinem der vorangehenden Ansprüche, dadurch gekennzeichnet, daß es die folgenden Operationen umfaßt:

(a) Ersetzen des Sensors (41) durch ein Kalibrierungselement (51) mit bekanntem Widerstand,
(b) Messen einer ersten kumulierten Zeit (NQ1cal), in der das Umschaltsignal (Q) während der Meßperiode den ersten logischen Pegel besitzt, um einen Kalibrierungsfaktor (Xcal) zu bestimmen,
(c) Ersetzen des Kalibrierungselements (51) durch den Sensor (41),
(d) Messen einer zweiten kumulierten Zeit (NQ1mes), in der das Umschaltsignal (Q) während der Meßperiode den ersten logischen Pegel besitzt,
(e) Multiplizieren der zweiten kumulierten Zeit (NQ1mes) mit dem Kalibrierungsfaktor (Xcal), um ein Ausgangssignal zu liefern, das den mittleren Strom ($I_{BS}$ave) repräsentiert, der während der Meßperiode durch den Sensor (41) fließt.

10. Verfahren nach Anspruch 9, das eine Testschaltung nach Anspruch 2 verwendet, dadurch gekennzeichnet, daß die Schritte (b) und (d) das Zählen der Anzahl der Zyklen während der Meßperiode, in denen das Umschaltsignal (Q) den ersten logischen Pegel besitzt, umfaßt.

11. Verfahren nach Anspruch 9, das eine Testschaltung nach Anspruch 7 verwendet, dadurch gekennzeichnet, daß die Schritte (b) und (d) das Zählen der Anzahl von Taktzyklen, in denen der Ausgang (Q) während der Meßperiode auf dem ersten logischen Pegel liegt, umfaßt.

Fig.1

# Fig.2

# Fig.3